**Europäisches Patentamt**

**European Patent Office**

**Office européen des brevets**

(11) Veröffentlichungsnummer: **0 474 908 A1**

## EUROPÄISCHE PATENTANMELDUNG

(21) Anmeldenummer: **90117687.5**

(22) Anmeldetag: **13.09.90**

(51) Int. Cl.5: **H03M 5/12**, H04L 25/49, G11B 20/14

(43) Veröffentlichungstag der Anmeldung:
**18.03.92 Patentblatt 92/12**

(84) Benannte Vertragsstaaten:
**AT BE CH DE DK ES FR GB GR IT LI LU NL SE**

(71) Anmelder: **SIEMENS AKTIENGESELLSCHAFT**
**Wittelsbacherplatz 2**
**W-8000 München 2(DE)**

(72) Erfinder: **Mirthes, Reinhard**
**Am Hartfeld 4**
**W-8901 Eurasburg(DE)**

(54) **Verfahren zum Auswerten von in biphasecodierten Impulsfolgen enthaltenen Informationsbits.**

(57) Die Erfindung bezieht sich auf ein Verfahren zum Auswerten von in biphasecodierten Impulsfolgen enthaltenen Informationsbits, bei welchem entweder nur die ansteigenden oder die abfallenden Flanken der Impulsfolge erfaßt werden und die Informationsbits fortlaufend nach Maßgabe des Auftretens einer Flanke am Anfang oder in der Mitte einer biphasecodierten Bitzelle sowie des Abstandes dieser einen Flanke zur unmittelbar vorher erfaßten anderen Flanke abgeleitet werden.

## FIG 1

Die Erfindung bezieht sich auf ein Verfahren zum Auswerten von in biphasecodierten Impulsfolgen enthaltenen Informationsbits.

Es sind mittlerweile eine Vielzahl von integrierten Schaltungen für Fernsteuer-Sendebausteine bekannt, bei denen über eine Eingangsmatrix, z. B. Tastenfeld, eine Befehlsinformation festgelegt und im Biphase-Code ausgegeben wird. Ein Beispiel für eine solche integrierte Schaltung ist der SDA 2208 von Siemens.

Bezeichnend für biphasecodierte Impulsfolgen ist, daß jede Bitzelle aus einer logischen 1 und einer logischen 0 besteht. Die Information liegt in der Reihenfolge der beiden Zustände. In der Mitte eines biphasecodierten Impulses muß definitionsgemäß ein Zustandswechsel liegen. Die Richtung der Flanke bzw. die Reihenfolge der logischen Zustände 1 oder 0 erhalten die Information. Von besonderem Vorteil bei biphasecodierten Impulsen ist die Tatsache, daß die Impulsfolge implizit den Takt, der die asynchrone Abtastung auf der Empfangsseite ermöglicht, enthält.

Um eine biphasecodierte Impulsfolge auswerten zu können, ist es im allgemeinen notwendig, vom Anfang der Impulsfolge bis zu dessen Ende ständig die Zustandswechsel von logisch 1 auf logisch 0 und umgekehrt abzufragen und auszuwerten. Bei rechnergestützten Empfangseinrichtungen für biphasecodierte Impulsfolgen ist daher eine Interruptroutine notwendig, deren Dauer vom Anfang der Impulsfolge bis zu dessen Ende bestimmt ist.

Da im allgemeinen jedoch eine Vielzahl von Interruptroutinen für unterschiedlichste Funktionen beispielsweise in nachrichtentechnischen Geräten vorgesehen werden, ist es notwendig, die Dauer von Interruptroutinen zeitlich gering zu halten. Bei mikrocomputergesteuerten Fernsehgeräten werden solche Interruptroutinen neben der Auswertung von Fernsteuersignalen, dem Auffrischen von LED-Anzeigen im Multiplexbetrieb, On-Screen-Einblendung für Benutzerführung usw. benötigt. Daher ist es wünschenswert und notwendig die Interruptroutinen zur Auswertung von über Fernsteuersender ausgestrahlte biphasecodierte Impulsfolgen, die die Befehlsinformation zum Verändern der Betriebsbedingungen des Fernsehgeräts enthalten, möglichst in zeitlichen Grenzen zu halten.

Der Erfindung liegt die Aufgabe zugrunde, ein Verfahren zum Auswerten von in biphasecodierten Impulsfolgen enthaltenden Informationsbits anzugeben, das bei rechnergestützter Decodierung eine geringe Rechnerbelastung hervorruft.

Die Erfindung wird durch die Merkmale des Anspruchs 1 gelöst.

Weiterbildungen der Erfindung sind Gegenstand der Unteransprüche.

Eine bevorzugte Verwendung des Verfahrens ist in einem nachrichtentechnischen Gerät zur Auswertung von über eine Fernbedienung abgegebenen und in einem nachrichtentechnischen Gerät angeordneten Fernbedienungsempfänger empfangenen biphasecodierten Impulsfolge vorgesehen.

Die Erfindung wird im folgenden anhand von zwei Ausführungsbeispielen im Zusammenhang mit zwei Figuren näher erläutert. Es zeigen:

FIG 1    ein Impulsdiagramm, bei dem zur Auswertung der Informationsbits das Auftreten positiver Flanken erfaßt wird und

FIG 2    ein Impulsdiagramm nach FIG 1, bei dem zur Auswertung der Informationsbits das Auftreten der negativen Flanken erfaßt wird.

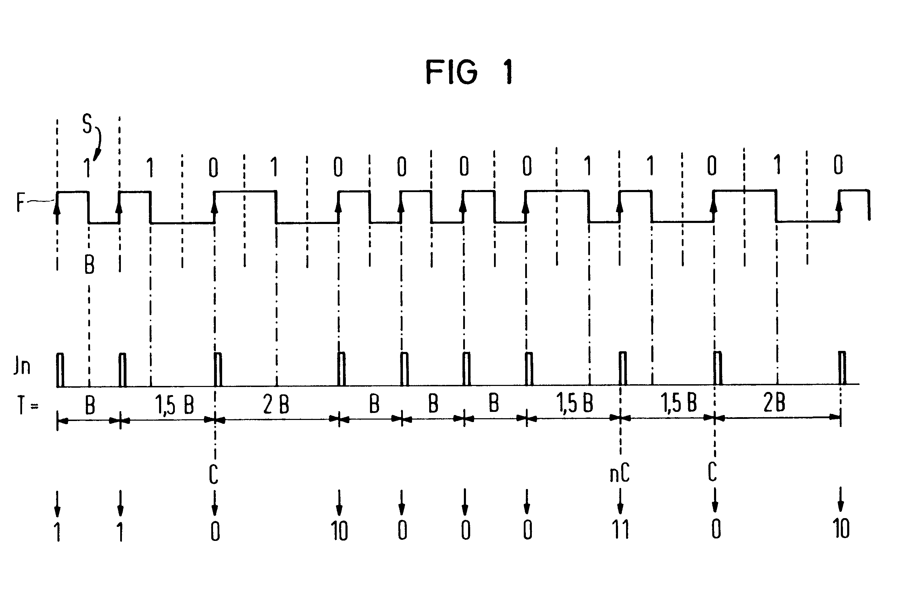

In FIG 1 ist das erfindungsgemäße Verfahren anhand eines Impulsdiagrammes, einer Impulsfolge F mit aufeinanderfolgenden Informationsbits 1101000011010 dargestellt, wie diese beispielsweise von einem drahtgebundenen oder drahtlosen Fernsteuersender eines nachrichtentechnischen Gerätes abgegeben und - vorausgesetzt daß keine Störungen auftreten - im Fernbedienungsempfänger des nachrichtentechnischen Gerätes wieder empfangen werden. Jedes dieser Informationsbits weist eine Bitbreite B auf, in welcher die logischen Zustände 0 und 1 einmal abwechseln. Die Bitinformation liegt in der Reihenfolge dieser beiden logischen Zustände. Auf der halben Bitbreite B liegt jeweils ein Zustandswechsel. Eine logische 1 mit nachfolgender logischer 0 kennzeichnet ein Informationsbit 1 und eine logische 0 mit nachfolgender logischer 1 ein Informationsbit 0.

Zur Auswertung der biphasecodierten Impulsfolge in der Empfangseinrichtung wird in FIG 1 das Auftreten der ansteigenden Flanken erfaßt, was durch die in der Impulsfolge F in den ansteigenden Flanken dargestellten Pfeilen angedeutet ist.

Das erfindungsgemäße Verfahren sieht vor, daß der Abstand T einer Flanke zu einer unmittelbar vorher auftretenden Flanke gleicher Richtung bestimmt wird und zusätzlich bei einem Abstand vom 1,5-fachen der Bitbreite B festgestellt wird, ob die eine Flanke in der Mitte der biphasecodierten Bitzelle oder an deren Anfang auftritt. Eine Bitzelle ist dabei bestimmt durch den Beginn einer logischen 1 bis zum Ende einer logischen 0 für ein Informationsbit 1 bzw. durch den Beginn einer logischen 0 bis zum Ende einer logischen 1 für ein Informationsbit 0.

Für die sich aus dem Impulsdiagramm F ergebenden Abstände T jeweils zweier aufeinanderfolgenden Flanken ergeben sich daher die in FIG 1 bezeichneten Werte B; 1,5 B; 2 B; B usw.

Wird zusätzlich noch bestimmt, ob eine Flanke in der Mitte der Bitzelle auftritt oder nicht, so können in einfacher Weise unter Berücksichtigung der nachfolgenden Zuordnungstabelle TAB 1 die Informationsbits der Impulsfolge F dekodiert werden.

TAB 1

|  | Informationsbit |
|---|---|
| T = B | neues Informationsbit = altes |
| T = 1,5 B; C | neues Informationsbit = 0 |
| T = 1,5 B, n C | neue Informationsbit = 11 |
| T = 2 B | neue Informationsbit = 10 |

In der Tabelle 1 und in der FIG 1 bedeutet C, daß die Flanke in der Mitte der Bitzelle auftritt und nC, daß die Flanke nicht in der Bitzellenmitte liegt.

Von besonderem Vorteil ist, wenn die Impulsfolge ein vorbestimmtes Startsignal, insbesondere ein vorbestimmtes Startbit aufweist. Das Startbit ist in FIG 1 das erste in der Impulsfolge F auftretende Informationsbit und mit S bezeichnet. Es ist hier mit dem logischen Wert 1 belegt. Damit ergibt sich eindeutig für die erste erfaßte Flanke, daß ein Startbit mit dem logischen Wert 1 empfangen wurden.

Obwohl das erfindungsgemäße Verfahren in beliebiger Weise schaltungstechnisch realisiert werden kann, bietet sich eine rechnergestützte Lösung insbesondere dann an, wenn ohnehin ein Mikrocomputer zur Verfügung steht, wie dies z. B. bei modernen Fernsehgeräten oder Rundfunkgeräten üblich ist. In diesem Fall ist es vorgesehen, daß jede ansteigende Flanke einen Interruptimpuls auslöst, bei dem der Mikrocomputer in eine Interruptroutine zum Auswerten des oder der Informationsbits gemäß der Tabelle 1 übergeht. Die Interruptimpulse In sind in FIG 1 ebenfalls dargestellt.

Der wesentliche Vorteil liegt bei dem hier vorgestellten Verfahren in den kurzen Interruptroutinen, die deutlich unterhalb der bisher notwendigen Interruptroutinen zum Auswerten eines kompletten Impulsdiagrammes vom Anfang des ersten Informationsbits bis zum Ende des letzten Informationsbits nötig war. So kann beisielsweise ein vom eingangs erwähnten integrierten Fernsteuer-Sendebaustein SDA 2208 ausgegebener Befehl in Form einer Impulsfolge bestehend aus Vorsignal, Pause, Startbit und 9 Informationsbits durch 11 einzelnen Interruptroutinen mit insgesamt ca. 350 $\mu$sec Dauer ausgewertet werden, während 2, 3 msec nötig waren. Damit läßt sich die Rechnerbelastung im Empfangsgerät deutlich reduzieren.

Anzumerken ist noch , daß das Vorsignal beim SDA 2208 eine Dauer von 256/Oszillatorfrequenz des SDA 2208 hat. Es erlaubt empfängerseitig eine einfache Pegelregelung des Eingangsverstärkers. Die Pause dauert vom Ende des Vorsignales bis zum Beginn des Startbits. Sie ermöglicht dem Empfänger Übertragungsstörungen bei Grenzreichweite zu erkennen. Das Startbit ist fest auf logisch 1 programmiert.

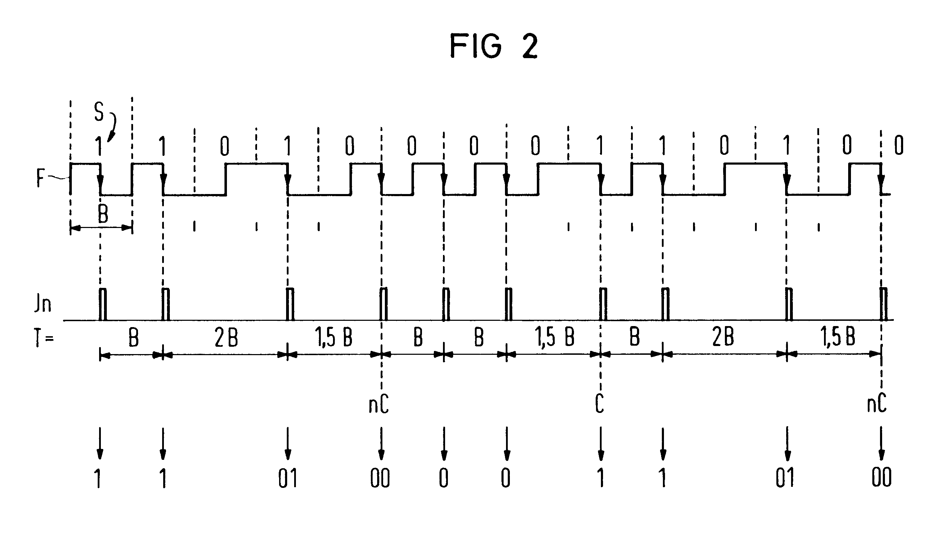

In FIG 2 ist eine zu FIG 1 identische Impulsfolge F dargestellt, bei der jetzt allerdings ausschließlich die abfallenden Flanken zur Auswertung der Informationsbits erfaßt werden. Die Bezugszeichen B, S, F, In, T, C und nC haben wieder die gleiche Bedeutung wie in FIG 1.

Um die Informationsbits aus den abfallenden Flanken ableiten zu können, ist folgende Zuordnungstabelle TAB 2 notwendig:

TAB 2

|  | Informationsbit |
|---|---|
| T = B | neues Informationsbit = altes |
| T = 1,5 B; C | neues Informationsbit = 1 |
| T = 1,5 B, n C | neue Informationsbit = 00 |
| T = 2 B | neue Informationsbit = 01 |

Wie in FIG 2 dargestellt ist, ergibt sich bei einem fest vorgegebenen Startbit S = 1 für die erste Flanke ein Informationsbit 1, für die zweite auftretende Flanke ebenfalls ein Informationsbit 1, da der Abstand T von der ersten Flanke zur zweiten Flanke gleich einer Bitbreite B ist. Die dritte Flanke tritt mit einem Abstand von 2 Bitbreiten B auf, womit die Informationsbits 01 erhalten werden. Die vierte Flanke hat einen Abstand von 1,5 B zur dritten Flanke, wobei die Flanke nicht in der Bitzellenmitte auftritt. Daraus folgt, daß zwei Informationsbits mit den logischen Zuständen 00 empfangen wurden. Die restlichen Informationsbits

3

00110100 werden entsprechend TAB 2 ermittelt.

**Patentansprüche**

1. Verfahren zum Auswerten von in biphasecodierten Impulsfolgen enthaltenen Informationsbits, bei welchem entweder nur die ansteigenden oder nur die abfallenden Flanken der Impulsfolge (F) erfaßt werden und die Informationsbits fortlaufend nach Maßgabe des Auftretens einer Flanke am Anfang oder in der Mitte einer biphasecodierten Bitzelle sowie des Abstandes (T) dieser einen Flanke zur unmittelbar vorher erfaßten anderen Flanke abgeleitet werden.

2. Verfahren zum Auswerten von in biphasecodierten Impulsfolgen enthaltenen Informationsbits nach Anspruch 1,
   **dadurch gekennzeichnet,**
   daß nur die ansteigenden Flanken erfaßt und ein oder zwei neue Informationsbits in der Weise erhalten werden, daß bei einem Abstand (T) von einer Bitbreite (B) der einen Flanke zur unmittelbar vorher erfaßten anderen Flanke das neue Informationsbit identisch zum unmittelbar vorher auftretenden Informationsbit gewählt wird, bei einem Abstand von zwei Bitbreiten (B) zwei neuen Informationsbits die logischen Zustände 10 zugeordnet werden und bei einem Abstand (T) der 1,5-fachen Bitbreite ein neues Informationsbit den logischen Zustand 0 erhält, wenn die eine Flanke in der Mitte der biphasecodierten Bitzelle auftritt und zwei neue Informationsbits mit den logischen Zuständen 11 erhalten werden, wenn die eine Flanke am Anfang der biphasecodierten Bitzelle auftritt.

3. Verfahren zum Auswerten von in biphasecodierten Impulsfolgen enthaltenen Informationsbits nach Anspruch 1,
   **dadurch gekennzeichnet,**
   daß nur die abfallenden Flanken erfaßt und ein oder zwei neue Informationsbits in der Weise erhalten werden, daß bei einem Abstand (T) von einer Bitbreite der einen Flanke zur unmittelbar vorher erfaßten anderen Flanke das neue Informationsbit identisch zum unmittelbar vorher auftretenden Informationsbit gewählt wird, bei einem Abstand (T) von zwei Bitbreiten (B) zwei neuen Informationsbits die logischen Zustände 01 zugeordnet werden und bei einem Abstand der 1,5-fachen Bitbreite ein neues Informationsbit den logischen Zustand 1 erhält, wenn die eine Flanke in der Mitte der biphasecodierten Bitzelle auftritt und zwei neue Informationsbits mit den logischen Zuständen 00 erhalten werden, wenn die eine Flanke am Anfang der biphasecodierten Bitzelle auftritt.

4. Verfahren zum Auswerten von in biphasecodierten Impulsfolgen enthaltenen Informationsbits nach einem der Ansprüche 1 bis 3,
   **dadurch gekennzeichnet,**
   daß die biphasecodierte Impulsfolge ein vorbestimmtes Startsignal aufweist.

5. Verfahren zum Auswerten von in biphasecodierten Impulsfolgen enthaltenen Informationsbits nach einem der Ansprüche 1 bis 3,
   **dadurch gekennzeichnet,**
   daß die biphasecodierte Impulsfolge ein Vorsignal, ein Startsignal und nachfolgende Informationssignale aufweist.

6. Verfahren zum Auswerten von in biphasecodierten Impulsfolgen enthaltenen Informationsbits nach Anspruch 4 oder 5,
   **dadurch gekennzeichnet,**
   daß das vorbestimmte Startsignal ein Startbit (S) mit einem vorbestimmten logischen Zustand ist.

7. Verwendung des Verfahrens nach einem der Ansprüche 1 bis 6, in einem nachrichtentechnischen Gerät zur Auswertung von über eine Fernbedienung abgegebenen und in einem nachrichtentechnischen Gerät angeordneten Fernbedienungsempfänger empfangenen biphasecodierten Impulsfolgen.

# FIG 1

EP 0 474 908 A1

FIG 2

Europäisches
Patentamt

EUROPÄISCHER
RECHERCHENBERICHT

Nummer der Anmeldung

EP 90 11 7687

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 377 335  (SAMSUNG ELECTRONICS CO.)<br>* das ganze Dokument *<br>– – – | 1,3-4,6-7 | H 03 M 5/12<br>H 04 L 25/49<br>G 11 B 20/14 |
| A | FR-A-2 632 795  (LA TELEMECANIQUE ELECTRIQUE)<br>* Seite 4, Zeile 4 - Seite 5, Zeile 18; Figuren 1-4 *<br>– – – | 1-3 | |
| A | US-A-4 027 267  (L.LARSEN)<br>* das ganze Dokument *<br>– – – – – | 1 | |

| RECHERCHIERTE SACHGEBIETE (Int. Cl.5) |
|---|
| H 03 M<br>H 04 L<br>G 11 B |

Der vorliegende Recherchenbericht wurde für alle Patentansprüche erstellt

| Recherchenort | Abschlußdatum der Recherche | Prüfer |
|---|---|---|
| Den Haag | 13 Mai 91 | KELPERIS K. |